# EUROPEAN PATENT SPECIFICATION

(11) **EP 0 307 231 B1**
(45) Date of publication and mention of the grant of the patent: **29.06.1994**
(21) Application number: 88308361.0
(22) Date of filing: 09.09.1988
(51) Int. Cl.: G02F 1/133, H01R 4/04

(54) **Display device**
Anzeigevorrichtung
Dispositif d'affichage

(30) Priority: 09.09.1987 JP 137714/87
(43) Date of publication of application: 15.03.1989
(73) Proprietor: SHARP KABUSHIKI KAISHA, Osaka 545 (JP)
(72) Inventor: Nakatani, Hiroshi, Tenri-shi Nara-ken (JP)
(74) Representative: Brown, Kenneth Richard

(56) References cited:
- PATENT ABSTRACTS OF JAPAN, vol. 10, no. 149 (P-461)[2206] May 30, 1986; & JP-A-61 003 126
- PATENT ABSTRACTS OF JAPAN, vol. 9, no. 253 (P-395)[1976] October 11, 1985; & JP-A-60 103 328

## Description

The present invention relates to a display device and an electrical connection assembly therefor. More particularly, the invention relates to a flat type display device which uses anisotropic conductive film for connection with a driver circuit.

Flat display panels such as LCD (liquid crystal display), ECD (electrochromic display), EL (electro luminescence) and PDP (plasma display panel) (hereinafter referred to as display panels) have electrodes with multiple terminals. Tape automated bonding (TAB) is one of the applicable techniques for mounting a driver LSI for driving a display device with multi-terminal electrodes: normally, a driver LSI is mounted on a tape carrier by inner lead bonding (ILB), and anisotropic conductive film is temporarily applied by pressure to the tape carrier on the surface to be in contact with the display panel. The tape carrier on which the driver LSI is mounted is positioned on the display panel and connected to the display panel under heat and pressure.

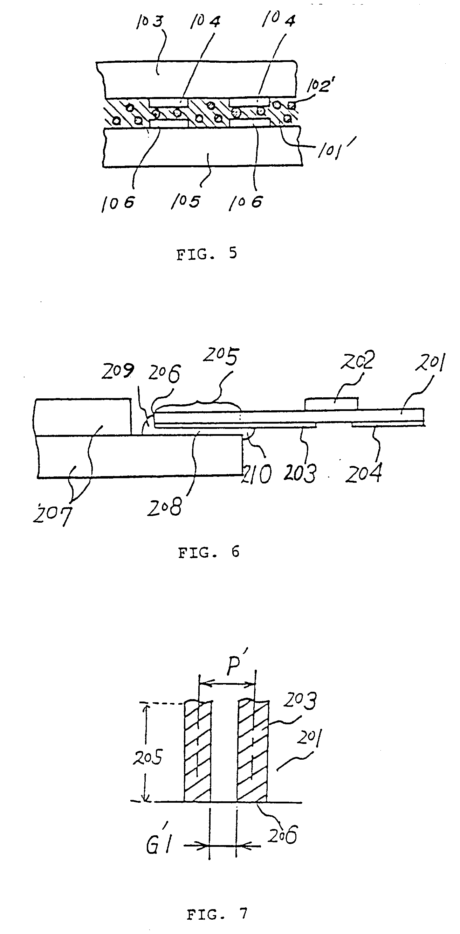

Here the anisotropic conductive film is described in detail. As shown in Fig. 5, the conventional anisotropic conductive resin tape for heat pressure connection contains conductive particles 102' such as Ag, Ni and Cu in powder form and carbon fibres in a resin tape 101'. The resin tape 101' clamped under a certain pressure between the terminals 104 on, say, a PC board 103 and the terminals 106 on a glass substrate 105 is heated. Then the adhesive property of the resin permits firm connection between the PC board 103 and the glass substrate 105. The conductive particles 102' existing between the terminals 104 and 106 effect electrical connection between the board 103 and the substrate 105. This type of anisotropic conductive film is disclosed in U.S. Patent 4,113,981. The anisotropic conductive film whose conductive particles 102' are elastic is disclosed in U.S. Patent 4,680,226.

The method of electrically connecting a driver LSI mounted on a tape carrier to the terminals of a display panel using anisotropic conductive film is described in the following with reference to Figs. 6 and 7.

The tape carrier comprises electrodes 203 and 204 formed on a base material 201. A driver LSI 202 is mounted by ILB in the centre of the tape carrier. The output of the LSI 202 is led to the cut end 206 of the tape carrier, and the input is led in the opposite direction. The output portion serves as an area 205 for connection with a display panel 207. Anisotropic conductive film 208 is temporarily applied by pressure to this contact area 205, and then the tape carrier is connected to the display panel 207 by heating under pressure.

With the tape carrier of the above construction, however, when the anisotropic conductive film 208 is heated under a pressure, it may be extended to the region between the electrodes and to the areas 209 and 210 outside the contact area 205. If metal particles in the anisotropic conductive film 208 extended to the areas 209 and 210 concentrate between the electrodes, a conducting path is formed by the metal particles, causing electrical leakage and/or short circuit.

In view of the above problem, an object of the present invention is to provide a display device in which the terminals of the driver circuit are connected to those of the flat display panel without causing leakage and/or short circuit.

Another object of the present invention is to provide a display device whose terminal configuration is designed so as not to cause leakage and/or short circuit when the terminals are electrically connected with each other via anisotropic conductive film.

In a first aspect, the invention provides an electrical connection assembly comprising:
a first support member having a plurality of first electrode terminals spaced apart from each other along an edge portion of said first support member, and
a second support member having a plurality of second electrode terminals spaced apart from each other along an edge portion of said second support member,
said two edge portions being superposed face-to-face with an anisotropic conductive layer sandwiched therebetween to provide the electrical connections between connection regions of said first electrode terminals and corresponding connection regions of said second electrode terminals,
characterised in that:
each of said connection regions of said first electrode terminals includes an end portion and/or an electrode portion having a width which is smaller than a width of the rest of said connection region,
said end portion is located at a position adjacent to the edge of said first support member and said electrode portion is located at a position adjacent to the edge of said second support member.

In a second aspect, the invention provides a display device including the assembly of the first aspect, wherein the first support member comprises a driver circuit and the second support member comprises a display panel.

The invention thus enables the electrode-to-electrode distance to be made larger at the end portion than at the central portion of the connecting part of the driver circuit electrode to be joined with the display panel electrode. Therefore, if the anisotropic conductive film is extended beyond the cut end of the tape carrier and metal particles contained in the anisotropic conductive film gather in the area beyond the cut end, electric leakage and/or short circuit never occur between the electrodes due to the large gap between the electrodes.
Fig. 1 is a plan view of a tape carrier of a display device, on which a driver LSI is mounted as a display device driver circuit by inner lead bonding;
Fig. 2 is an enlarged view of the part "A" of Fig. 1 as an embodiment of the present invention;
Fig. 3 is an enlarged view of the part "A" of Fig. 1 as another embodiment of the present invention;
Fig. 4 illustrates the connection between the display panel and the driver LSI according to the present invention;
Fig. 5 is a sectional view for explaining anisotropic conductive film; and
Figs. 6 and 7 are illustrations for explaining the connection between a display panel and a driver LSI according to the conventional art.

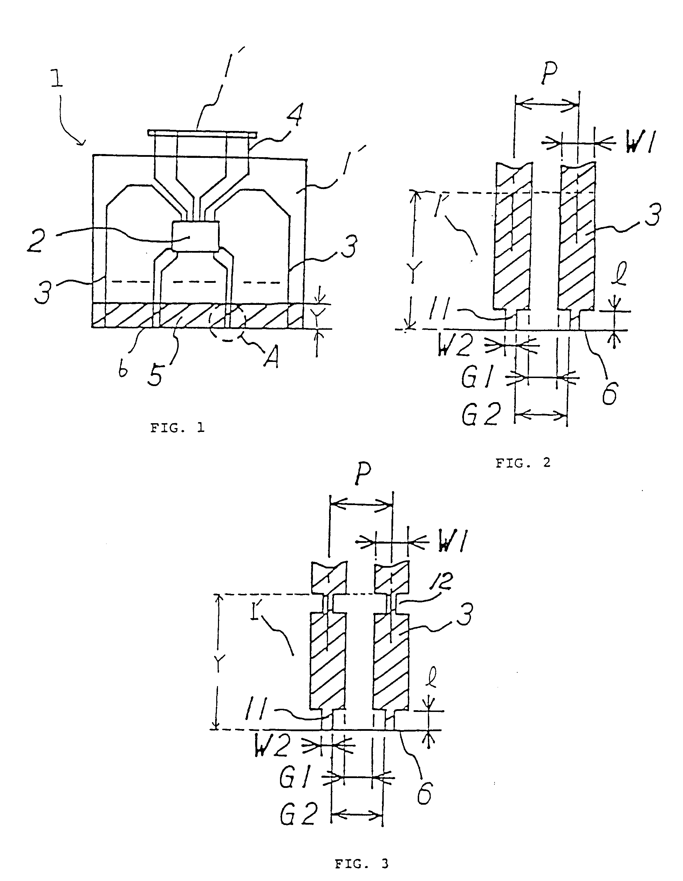

An embodiment of the present invention is described in the following with reference to Figs. 1 and 2.

This invention is applicable to a flat type display device such as LCD (liquid crystal display), ECD (electrochromic display), EL (electro luminescence) and PDP (plasma display panel). Normally, the flat display device has electrodes with multiple terminals to which the electrodes of an external circuit (a driver circuit, for instance) are connected.

An embodiment of the present invention is described below for the case where TAB (tape automated bonding) technique is used in mounting a driver LSI for driving a display device having multi-terminal electrodes.

According to the present embodiment, a driver LSI is mounted on a tape carrier by ILB (inner lead bonding), anisotropic conductive film is temporarily applied by pressure to the tape carrier on the surface to be brought in contact with a display panel, and the tape carrier with the driver LSI mounted thereon is positioned with respect to the display panel and connected with the display panel by heating under pressure.

Fig. 1 is a plan view of the tape carrier on which the driver circuit for driving the display device is mounted by inner lead bonding. Fig. 2 is an enlarged view of the part "A" of Fig. 1.

The tape carrier 1 comprises a plurality of electrode terminals 3 and a plurality of electrode terminals 4 formed on a polyimide or the like base material 1'. A driver LSI 2 is mounted in the centre of the tape carrier 1 by ILB. The electrode terminals of the driver LSI 2 are connected to the electrode terminals 3 and 4 on the tape carrier 1, respectively. The electrode terminals 3 are connected to the output side, and the electrode terminals 4 to the input side of the driver LSI 2. The output electrode terminals of the driver LSI 2 are led to the cut end 6 of the tape carrier 1, and the input electrode terminals to the opposite end of the tape carrier 1.

The portion in the region 5 of each electrode terminal 3 extended to the cut end 6 is connected with each of multiple electrode terminals 13 of the display panel. The electrode terminals 4 on the other side are connected with an external circuit (such as a power supply).

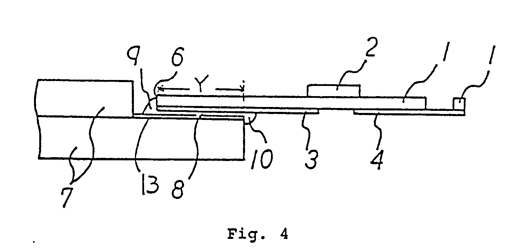

In this state, anisotropic conductive film is temporarily applied by pressure to the connecting region 5 of the tape carrier 1, and the electrode terminals 3 of the driver LSI 2 are positioned to correspond to the electrode terminals 13 of the display panel 7. The electrode terminals of the driver LSI 2 on the tape carrier 1 are then heated under a pressure for connection with the electrode terminals of the display panel 7 (see Fig. 4).

In this embodiment, to overcome the conventional problem, the electrode terminals of the driver LSI 2 are formed as described below. In the description, the length in the connecting region 5 of the driver LSI electrode terminals 3 to be connected with the display panel electrode terminals 13 is assumed to be Y, the width of each of the electrode terminals 3 is assumed to be W1, and the pitch between each two adjacent electrode terminals 3 is assumed to be P. In the connecting region 5 between the tape carrier 1 and the display panel 7, the end portion 11 near the cut end 6 of each electrode terminal 3 is formed narrower over a length of ℓ (ℓ = about 0.1 to 0.2mm) than the rest portion so that the width W1 of the electrode 3 becomes W2 in its end portion. This configuration makes the electrode-to-electrode gap in the end portion G2 (W1-W2) larger than that in the rest portion G1 which is calculated by (P-W1). With an electrode pitch P of about 300 »m and an electrode width W1 of about 150 »m, for instance, the electrode-to-electrode gap G1 is about 150 »m. With this condition, when about 100 pm, about 80 »m and about 50 »m are selected for the electrode width W2, the gap G2 becomes about 200 »m (130% of G1), about 220 »m (147% of G1) and about 250 »m (167% of G1). As a result, it is possible to prevent leakage and/or short circuit between electrodes if metal particles concentrate in the anisotropic conductive film portion 9 outside the cut end 6 of the tape carrier 1.

When anisotropic conductive film 8 is used in connecting the tape carrier 1 with the display panel 7, the anisotropic conductive film 8 can be pressed out not only to the area outside the cut end 6 but also to the area outside the panel end 10. Leakage and/or short circuit between electrodes in this area outside the display panel end 10 can be prevented by forming the electrode portion 12 in this area similarly to the end portion 11 of each electrode near the cut end 6, as shown in Fig. 3. This portion 12 of each electrode 3 is formed narrower over a length of ℓ (ℓ = about 0.1 mm to 0.2 mm, for example).

According to the present invention, as described above, at least the end portion in the connecting region of each electrode is formed narrower than the electrode in the central portion of the connecting region, thereby realizing a practically useful display device which has eliminated the possibility of leakage and/or short circuit in the end portions of the joint.

While only certain embodiments of the present invention have been described, it will be apparent to those skilled in the art that various changes and modifications may be made therein without departing from the scope of the present invention as claimed.

## Claims

1. An electrical connection assembly comprising:
a first support member (1) having a plurality of first electrode terminals (3) spaced apart from each other along an edge portion of said first support member (1), and
a second support member (7) having a plurality of second electrode terminals (13) spaced apart from each other along an edge portion of said second support member (7),
said two edge portions being superposed face-to-face with an anisotropic conductive layer (8) sandwiched therebetween to provide the electrical connections between connection regions (5) of said first electrode terminals (3) and corresponding connection regions of said second electrode terminals (13),
characterised in that:
each of said connection regions (5) of said first electrode terminals (3) includes an end portion (11) and/or an electrode portion (12) having a width (W₂) which is smaller than a width (W₁) of the rest of said connection region (5),
said end portion (11) is located at a position adjacent to the edge of said first support member (1) and said electrode portion (12) is located at a position adjacent to the edge of said second support member (7).

2. An assembly according to claim 1, wherein
the end portions in the connection regions of each electrode terminal (3, 13) have a reduced width relative to the rest of said connection regions.

3. A display device including an electrical connection assembly as claimed in claim 1 or claim 2, wherein said first support member comprises a driver circuit (2), and said second support member comprises a display panel (7).

4. A display device as claimed in claim 3, wherein said driver circuit (2) is a tape carrier (1) with a driver LSI mounted thereon.

5. A display device as claimed in claim 3 or claim 4, wherein said first electrode terminals (3) are connected to respective corresponding second electrode terminals (13) through said anisotropic conductive layer (8) of a type which forms connection when heated whilst under pressure.

## Patentansprüche

1. Elektrische Verbindungsanordnung mit:
- einem ersten Trägerteil (1) mit mehreren ersten Elektrodenanschlüssen (3), die voneinander entlang eines Kantenabschnitts des ersten Trägerteils (1) beabstandet sind; und
- einem zweiten Trägerteil (7) mit mehreren zweiten Elektrodenanschlüssen (13), die voneinander entlang eines Kantenabschnitts des zweiten Trägerteils (7) beabstandet sind;
- wobei die zwei Kantenabschnitte Kopf-an-Kopf übereinander liegen, wobei eine anisotrop leitende Schicht (8) zwischen ihnen eingebettet ist, um elektrische Verbindungen zwischen Verbindungsbereichen (5) der ersten Elektrodenanschlüsse (3) und entsprechenden Verbindungsbereichen der zweiten Elektrodenanschlüsse (13) zu schaffen;
**dadurch gekennzeichnet**, daß:
- jeder der Verbindungsbereiche (5) der ersten Elektrodenanschlüsse (3) einen Endabschnitt (11) und/oder einen Elektrodenabschnitt (12) mit einer Breite (W2) aufweist, die kleiner ist als die Breite (W1) des Rests des Verbindungsbereichs (5); und
- wobei der Endabschnitt (11) an einer Position benachbart zur Kante des ersten Trägerteils (1) liegt und der Elektrodenabschnitt (12) an einer Position benachbart zur Kante des zweiten Trägerteils (7) liegt.

2. Anordnung nach Anspruch 1, bei der die Endabschnitte in den Verbindungsbereichen jedes Elektrodenanschlusses (3, 13) eine Breite aufweisen, die gegenüber derjenigen im Rest der Verbindungsbereiche verringert ist.

3. Anzeigevorrichtung mit einer elektrischen Verbindungsanordnung nach Anspruch 1 oder Anspruch 2, bei der das erste Trägerteil eine Ansteuerschaltung (2) aufweist und das zweite Trägerteil ein Anzeigepaneel (7) aufweist.

4. Anzeigevorrichtung nach Anspruch 3, bei der die Ansteuerschaltung (2) ein Bandträger (1) mit einem auf diesem angebrachten Ansteuer-LSI ist.

5. Anzeigevorrichtung nach Anspruch 3 oder Anspruch 4, bei der die ersten Elektrodenanschlüsse (3) mit jeweils entsprechenden zweiten Elektrodenanschlüssen (13) über die anisotrop leitende Schicht (8) verbunden sind, die von einem Typ ist, der bei Erhitzen unter Druck eine Verbindung herstellt.

## Revendications

1. Ensemble de connexion électrique comprenant :
un premier élément de support (1) ayant plusieurs premières bornes d'électrodes (3) espacées les unes des autres le long d'une partie de bord dudit premier élément de support (1), et
un deuxième élément de support (7) ayant plusieurs deuxièmes bornes d'électrode (13) espacées les unes des autres le long d'une partie de bord dudit deuxième élément de support (7),
lesdites deux parties de bord étant superposées face à face, avec une couche conductrice anisotropique (8) intercalée entre les deux pour réaliser les connexions électriques entre les régions de connexion (5) desdites premières bornes d'électrode (3) et les régions de connexion correspondantes desdites deuxièmes bornes d'électrode (13),
caractérisé en ce que :
chacune desdites régions de connexion (5) desdites premières bornes d'électrode (3) inclue une partie d'extrémité (11) et/ou une partie d'électrode (12) ayant une largeur (W₂) inférieure à une largeur (W₁) du reste de ladite région de connexion (5),
ladite partie d'extrémité (11) occupe une position adjacente au bord dudit premier élément de support (1) et ladite partie d'électrode (12) occupe une position adjacente au bord dudit deuxième élément de support (7).

2. Ensemble suivant la revendication 1, dans lequel les parties d'extrémité des régions de connexion de chaque borne d'électrode (3, 13) ont une largeur réduite, par rapport au reste desdites régions de connexion.

3. Dispositif d'affichage comprenant un ensemble de connexion électrique tel que revendiqué dans la revendication 1 ou la revendication 2, dans lequel ledit premier élément de support comprend un circuit de commande (2) et ledit deuxième élément de support comprend un panneau d'affichage (7).

4. Dispositif d'affichage selon la revendication 3, dans lequel ledit circuit de commande (2) est constitué d'une bande de support (1) sur laquelle est monté un circuit de commande LSI.

5. Dispositif d'affichage selon la revendication 3 ou la revendication 4, dans lequel lesdites premières bornes d'électrode (3) sont connectées respectivement aux deuxièmes bornes d'électrode correspondantes (13) par l'intermédiaire de ladite couche conductrice anisotropique (8), d'un type qui établit la connexion lorsqu'elle est chauffée et en même temps sous pression.
